# EUROPEAN PATENT SPECIFICATION

(11) **EP 3 806 602 B1**
(45) Date of publication and mention of the grant of the patent: **06.08.2025**
(21) Application number: 18920765.7
(22) Date of filing: 30.05.2018
(51) Int. Cl.: H05K 13/02, H05K 13/04

(54) **TAPE FEEDER**
BANDZUFÜHRER
DISPOSITIF D'ALIMENTATION DE BANDE

(43) Date of publication of application: 14.04.2021
(73) Proprietor: Fuji Corporation, Chiryu-shi, Aichi 472-8686 (JP)
(72) Inventor: TANAKA, Keita, Chiryu-shi, Aichi 472-8686 (JP); HOSOI, Norio, Chiryu-shi, Aichi 472-8686 (JP)
(74) Representative: Grünecker Patent- und Rechtsanwälte PartG mbB
(86) International application number: PCT/JP2018/020678
(87) International publication number: WO 2019/229867

(56) References cited:
- EP-A1- 3 223 593
- EP-A1- 3 806 608
- EP-A2- 2 699 072
- EP-B1- 2 699 072
- EP-B1- 3 806 608
- WO-A1-2008/044638
- WO-A1-2015/189986
- WO-A1-2016/079785
- JP-A- H10 322 091

## Description

### TECHNICAL FIELD

The present description discloses a technique regarding a tape feeder including a reel displacement mechanism for holding a reel holder in such a manner as to be displaced in a width direction thereof relative to a feeder main body.

### BACKGROUND ART

As described in Patent Literature 1, which discloses the preamble of independent claim 1, in some of tape feeders configured to be attached to a feeder setting section of a component mounter, to save space, there is provided a reel displacement mechanism for holding a reel holder, in which a tape reel is loaded, in such a manner as to be displaced in a width direction thereof relative to a feeder main body. In this case, in attaching a tape feeder to a slot situated adjacent to a tape feeder which is already attached to the feeder setting section of the component mounter, a front or head end section (an end section directed in an attaching direction) of a feeder main body of the tape feeder to be attached is brought into abutment with a taper surface of a rear or tail end section (an end section directed in a removing direction) of a reel holder of the adjacent tape feeder, so as to displace the reel holder of the adjacent tape feeder in a width direction to a position which enables the tape feeder, which is brought into abutment with the reel holder, to be inserted. As a result, more tape feeders can be attached to the feeder setting section by making effective use of the space in the feeder setting section of the component mounter.

Patent Literature 2, falling under Art. 54(3) EPC, discloses a further example of a tape feeder.

### PATENT LITERATURE

Patent Literature 1: WO 2016/079785 A1
Patent Literature 2: EP 3 806 608 A1

### SUMMARY OF THE INVENTION

### TECHNICAL PROBLEM

In general, a reel holder in which a tape reel is loaded is formed from a resin, and a holder cover made of sheet metal is attached with a screw to at least a part of a side surface thereof for protection, reinforcement, or the like of the side surface. Due to this, in attaching or detaching a tape feeder to or from a tape feeder setting section of a component mounter, there is a possibility that end edges of the holder cover of the tape feeder which is attached or detached in attaching and detaching directions come into contact with an adjacent tape feeder. The holder cover tends to be deformed since the holder cover is formed of a thin sheet of stainless steel to make the tape feeder thin in thickness and light in weight. As a result, there is a case in which the holder cover is deformed into such a state that the end edges of the holder cover in the attaching and detaching directions are slightly raised from the side surface of the reel holder. As this occurs, the end edges in the attaching and detaching directions of the holder cover of the tape feeder which is attached or detached tend to be easily caught by the adjacent tape feeder, leading to a risk of the attachability and detachability of the tape feeder being deteriorated as a result of the end edges being so caught. Consequently, it is necessary to take some measures to improve the attachability and detachability of the tape feeder.

### SOLUTION TO PROBLEM

To solve the problem described above, the present invention provides a tape feeder as defined in independent claim 1. Preferred embodiments are laid down in the dependent claims.

Since the guide section is provided at both the end portions of the reel holder in the attaching and detaching directions to guide the tape feeder when the tape feeder is attached to or detached from the feeder setting section in such manner that the end edges in the attaching and detaching directions of the holder cover of the tape feeder are not caught by the adjacent tape feeder, the end edges in the attaching and detaching directions of the holder cover of the tape feeder that is attached or detached can be prevented from being caught by the adjacent tape feeder, thereby making it possible to improve the attachability and detachability of the tape feeder.

### BRIEF DESCRIPTION O DRAWINGS

[Fig. 1] Fig. 1 is a perspective view of a tape feeder according to an embodiment.
[Fig. 2] Fig. 2 is a side view of the tape feeder.
[Fig. 3] Fig. 3 is a side view of a feeder main body from which a reel holder is removed.
[Fig. 4] Fig. 4 is a side view of the reel holder.
[Fig. 5] Fig. 5 is a sectional view of an upper section side of a slide mechanism taken along line V-V in Fig. 2 and viewed from below.
[Fig. 6] Fig. 6 is a sectional view of a lower section side of the slide mechanism taken along line VI-VI in Fig. 2 and viewed from below.
[Fig. 7] Fig. 7 is a vertically sectional front view showing in an enlarged fashion a holding structure at an upper end face side of the tape feeder set in a feeder setting section of a component mounter.
[Fig. 8] Fig. 8 is a partially taken away side view showing in an enlarged fashion a clamp structure at the upper end face side of the tape feeder set in the feeder setting section of the component mounter.
[Fig. 9] Fig. 9 is a sectional view taken along line IX-IX in Fig. 2.
[Fig. 10] Fig. 10 is a perspective view of a guide section.
[Fig. 11] Fig. 11 is a perspective view showing a guide section attached to an end section in a detaching direction of the reel holder and a peripheral section thereof.
[Fig. 12] Fig. 12 is a sectional view taken along line XII-XII in Fig. 11.
[Fig. 13] Fig. 13 is a sectional view taken along line XIII-XIII in Fig. 11.

### Description of Embodiment

Hereinafter, an embodiment, which is disclosed in the present description, will be described. Firstly, an overall configuration of tape feeder 10 will be described.

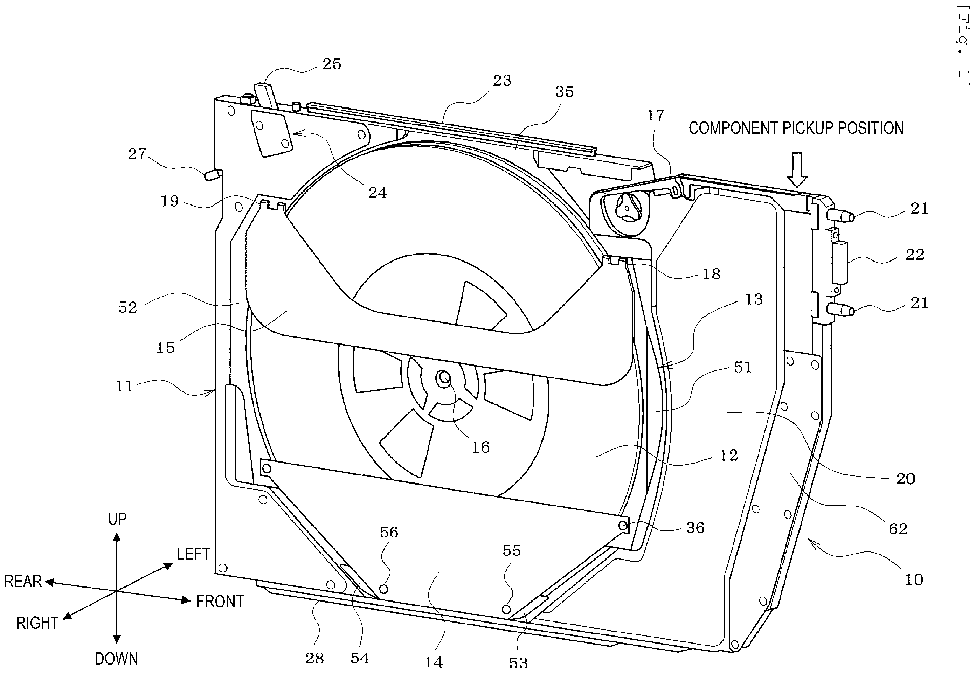

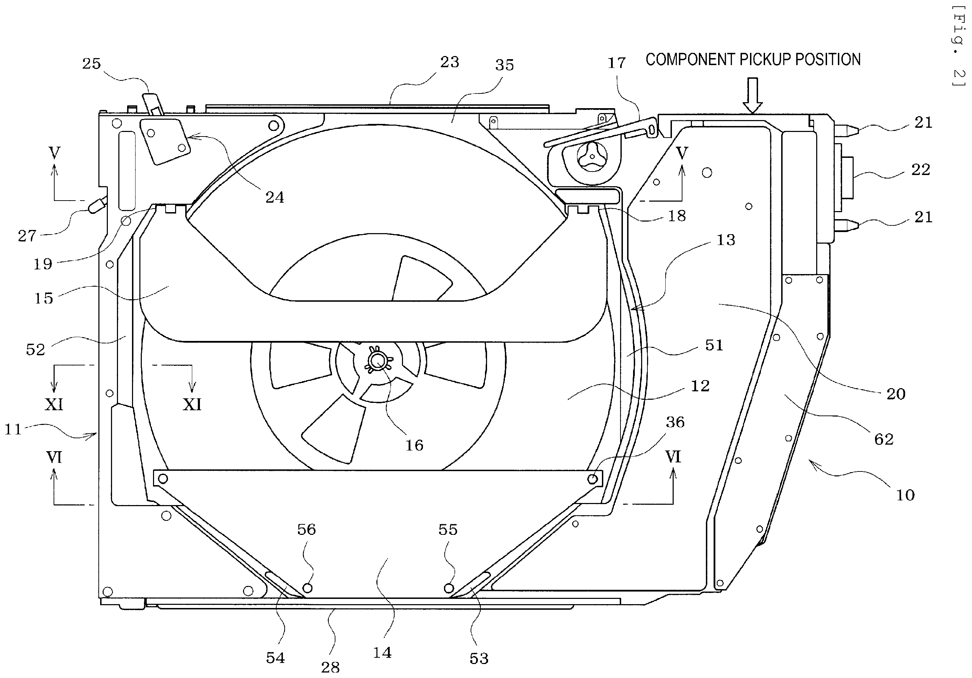

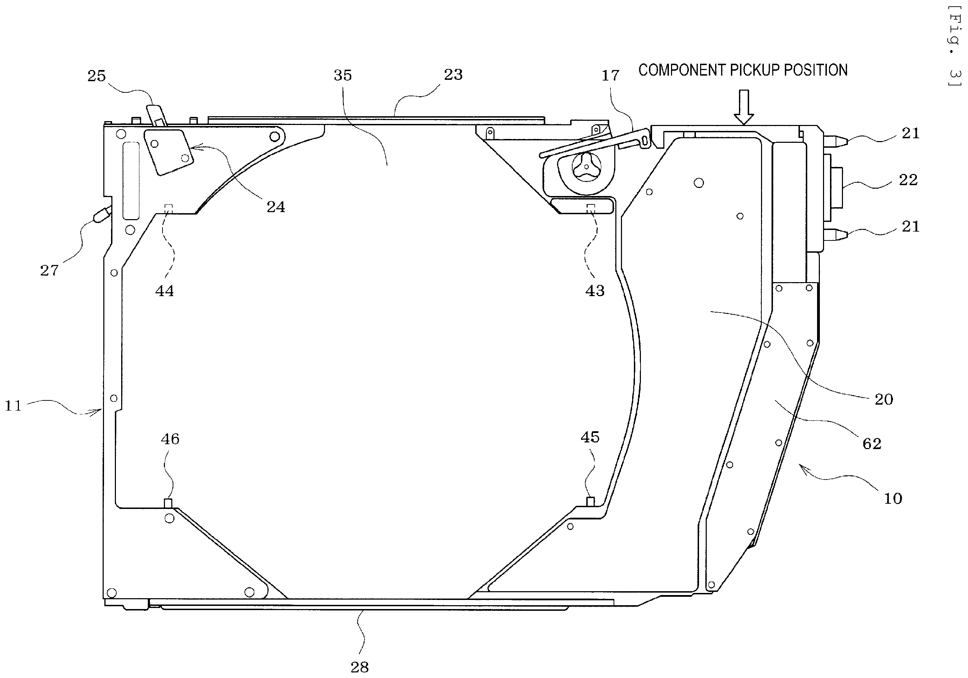

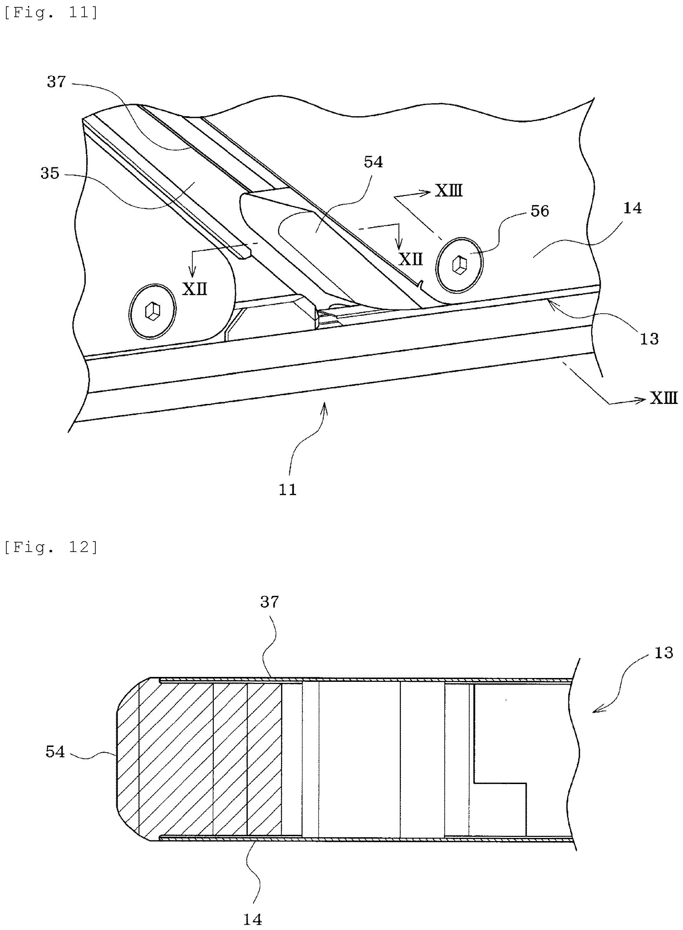

As show in Figs. 1 and 2, feeder main body 11 of tape feeder 10 is formed flat. Hole section 35 (refer to Fig. 3) is formed in this feeder main body 11 in such a manner as to allow resin reel holder 13, in which tape reel 12 around which a component supply tape (not shown) is wound is loaded rotatably, to pass therethrough in a width direction thereof. Reel holder 13 is provided within hole section 35 in feeder main body 11 via a reel displacement mechanism (slide mechanisms 41, 42), which will be described later, in such a manner as to be displaced in the width direction (a left-right direction) of reel holder 13 in question. Holder cover 14, which is made of sheet metal such as a sheet of stainless steel, is attached with screws 36 to a front surface side (a right surface side) of a lower-side portion of reel holder 13 in such a manner as to cover a lower-side portion of tape reel 12. This holder cover 14 extends as far as a lower end portion of reel holder 13. Reel presser plate 15, which is configured to cover an upper-side portion of tape reel 12 accommodated within holder cover 14, is provided on a front surface side of an upper-side portion of reel holder 13 in such a manner as to be swung to be opened and closed about hinge sections 18, 19 at both sides of an upper end portion thereof as fulcrums. Additionally, holder cover 37 (refer to Figs. 11 and 12), which is made of sheet metal such a sheet of stainless steel and which extends as far as a lower end portion of reel holder 13, is also attached to a rear surface side (a left surface side) of the lower-side portion of reel holder 13 with screws (not shown).

When tape reel 12 is removed from reel holder 13, reel presser plate 15 is swung upwards about hinge sections 18, 19 at both the sides of the upper end portion thereof as the fulcrums to open the upper-side portion of reel holder 13, and then, tape reel 12 is pulled out obliquely upwards while grabbing an upper side of tape reel 12 inside reel holder 13 with fingers to slightly incline tape reel 12 towards a near side. When tape reel 12 is loaded in reel holder 13, loading tape reel 12 in reel holder 13 is completed by inserting tape reel 12 obliquely from above into reel holder 13 with reel presser plate 15 left open so that a lower-side portion of tape reel 12 is put in an inside of holder cover 14 and closing reel presser plate 15. A closed state of reel presser plate 15 is held by a magnet, a spring, or the like.

In this case, a configuration may be adopted in which a short reel holding shaft (not shown), which is configured to fit in center hole 16 in tape reel 12, is provided at a central portion of reel holder 13, so that tape reel 12 is supported rotatably by the short reel holding shaft. In the case that this configuration is adopted, it is preferable that a length of reel holding shaft is made shorter than a length of center hole 16 in tape reel 12 (for example, a length of a half or one third of the length of center hole 16) so that the reel holding shaft, which fits in center hole 16 in tape reel 12, deteriorates the attachability and detachability of tape reel 12. Alternatively, a configuration may be adopted in which multiple rollers (not shown) are provided along an outer circumference of tape reel 12 at a lower side of reel holder 13 (inside holder cover 14), so that the outer circumference of tape reel 12 is borne and supported rotatably by the multiple rollers.

A component pickup position, where a component is picked up by a pickup nozzle (not shown) of the component mounter, is set in a position near an end face portion of an upper end face section of feeder main body 11 which lies frontmost (at a front side) in an attaching direction of feeder main body 11. Tape guide 17, which is configured to guide a component supply tape pulled out of tape reel 12 to the component pickup position, is provided at a lower side of the upper end face section of feeder main body 11.

A space defined in feeder main body 11 between reel holder 13 and the end face portion of feeder main body 11 which lies frontmost (at the front side) in the attaching direction thereof constitutes electric equip;ment accommodating space 20. This electrical equipment accommodating space 20 accommodates various types of electrical equipment including a tape feeding device (not shown) for pulling out the component supply tape from tape reel 12 in reel holder 13 to feed the component supply tape so pulled out to the component pickup position, a control section (not shown) for controlling a pitch feeding operation performed by the tape feeding device, and the like.

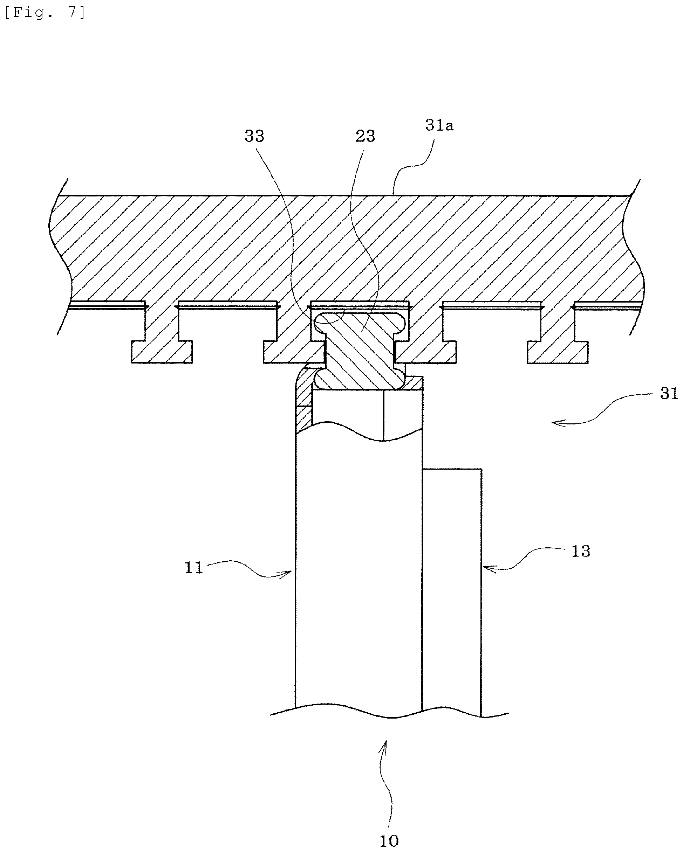

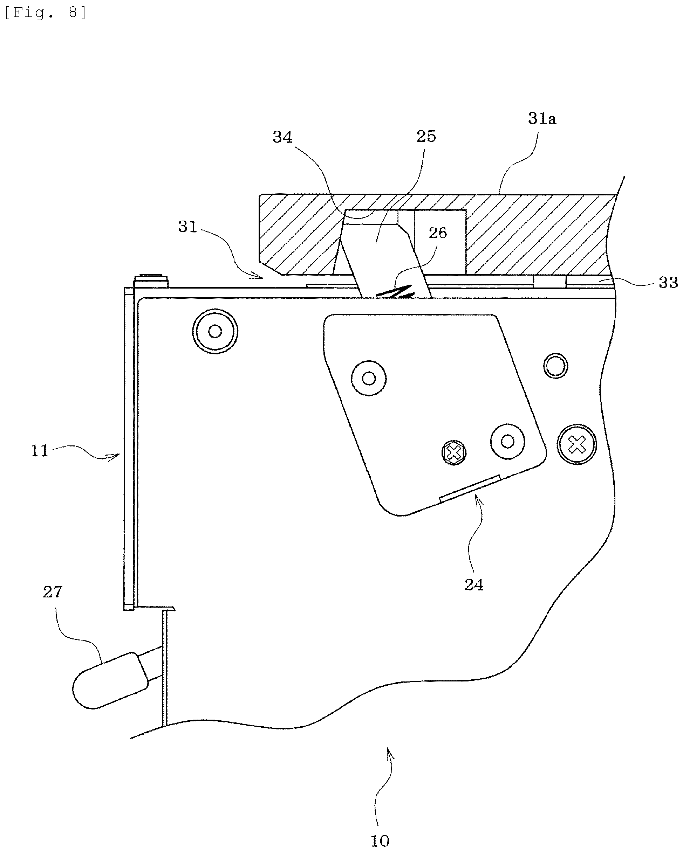

Two positioning pins 21, 21, which are configured to position tape feeder 10 or feeder main body 11 with respect to feeder setting section 31 (refer to Figs. 7 and 8) of the component mounter, are provided in such a manner as to be spaced apart at a predetermined interval in an up-down direction at the front end face portion of feeder main body 11 which lies frontmost (at the front side) in the attaching direction thereof in a position higher than a height-wise center of the end face portion (in the present embodiment, a position near the upper end face section of feeder main body 11). Connector 22 for power supply and communication is provided between these two positioning pins 21, 21, and by inserting connector 22 on feeder main body 11 into a connector (not shown) on the component mounter for connection, power is supplied from the component mounter to the various types of electrical equipment including the tape feeding device, the control section, and the like provided inside feeder main body 11, and various types of signals such as a control signal, a sensor signal, and the like are transmitted and received between a control section (not shown) on the component mounter and the control section on feeder main body 11.

Next, a configuration will be described which holds a state in which feeder main body 11 is attached to feeder setting section 31 of the component mounter.

As shown in Figs. 1 and 2, guide rail 23 having a T-shaped cross section is provided, as a holding member, at a portion of the upper end face section of feeder main body 11 which lies at the upper-side portion of reel holder 13 in such a manner as to extend in the attaching and detaching directions (the front-rear direction) of feeder main body 11. To match guide rail 23 so provided, as shown in Figs. 7 and 8, slot groove 33, in which guide rail 23 having the T-shaped cross section fits in such a manner as to slide and move in the attaching and detaching directions of feeder main body 11, is provided on upper-side member 31a of feeder setting section 31 of the component mounter in such a manner as to extend in the attaching and detaching directions of feeder main body 11, and guide rail 23 having the T-shaped cross section on feeder main body 11 fits in slot groove 33 having the T-shaped cross section on feeder setting section 31, whereby feeder main body 11 is held in a state in which feeder main body 11 is guided so as to slide and move in the attaching and detaching directions and is prevented from being dislocated downwards. As shown in Fig. 7, multiple slot grooves 33 are provided at predetermined intervals on upper-side member 31a of feeder setting section 31, so that multiple tape feeders 10 can be set on feeder setting section 31 in such a manner as to be aligned side by side in the left-right direction.

In addition, clamping device 24 (refer to Fig. 8), which is configured to clamp feeder main body 11 in such a state in which feeder main body 11 is attached to feeder setting section 31 of the component mounter, is provided on the upper end face section of feeder main body 11 in a position lying near an end face portion (at a rear side) in the detaching direction of feeder main body 11. This clamping device 24 includes clamp member 25, which projects obliquely upwards from the upper end face section of feeder main body 11 for clamping, spring 26 such as a spring for biasing clamp member 25 obliquely upwards, that is, a clamping direction, and operation lever 27, which is operated for a clamp releasing operation in which clamp member 25 is retracted obliquely downwards, that is, in a clamp releasing direction. Operation lever 27 is disposed in such a manner as to project from the end face portion of feeder main body 11 which lies in the detaching direction (at the rear side) of feeder main body 11.

On the other hand, as shown in Fig. 8, clamp hole 34 is provided on an upper side of feeder setting section 31 of the component mounter in a position corresponding to clamp member 25, and feeder main body 11 is clamped in the attached state by clamp member 25 fitting in this clamp hole 34. In this case, when clamp member 25 is pushed up obliquely upwards in the detaching direction (at the rear side) of feeder main body 11 by spring 26, an upper end portion of clamp member 25 is put in a state in which the upper end portion is pressed against a side surface of clamp hole 34 which lies in the detaching direction (at the rear side) of feeder main body 11, and feeder main body 11 is pressed in the attaching direction (towards the front side) thereof by means of a reaction of the pressing of clamp member 25 against clamp hole 34, whereby not only is feeder main body 11 positioned with good accuracy, but also the connection state of connector 22 is held properly.

As shown in Figs. 1 and 2, guide rail 28 having an I-shaped cross section is provided as a lower holding member on a lower end face section of feeder main body 11 in such a manner as to extend in the attaching and detaching directions of feeder main body 11. To match guide rail 28 so provided, a rail groove (not shown), in which guide rail 28 having the I-shaped cross section on feeder main body 11 fits in such a manner as to slide and move in the attaching and detaching directions of feeder main body 11, is provided on a lower-side member (not shown) of feeder setting section31 of the component mounter, and when guide rail 28 having the I-shaped cross section on feeder main body 11 fits in the rail groove of the I-shaped cross section on the lower side member of feeder setting section 31, not only is feeder main body 11guided so as to slide and move in the attaching and detaching directions guided but also is held in such a manner as to be allowed to be dislocated upwards. As a result, even though a variation in production of feeder setting section 31 of the component mounter in relation to a height dimension or a variation in production of feeder main body 11 in relation to a height dimension is increased somehow, a friction resistance is prevented from being increased when feeder main body 11 slides and moves in the attaching and detaching directions thereof, whereby attaching and detaching of feeder main body 11 can be performed smoothly.

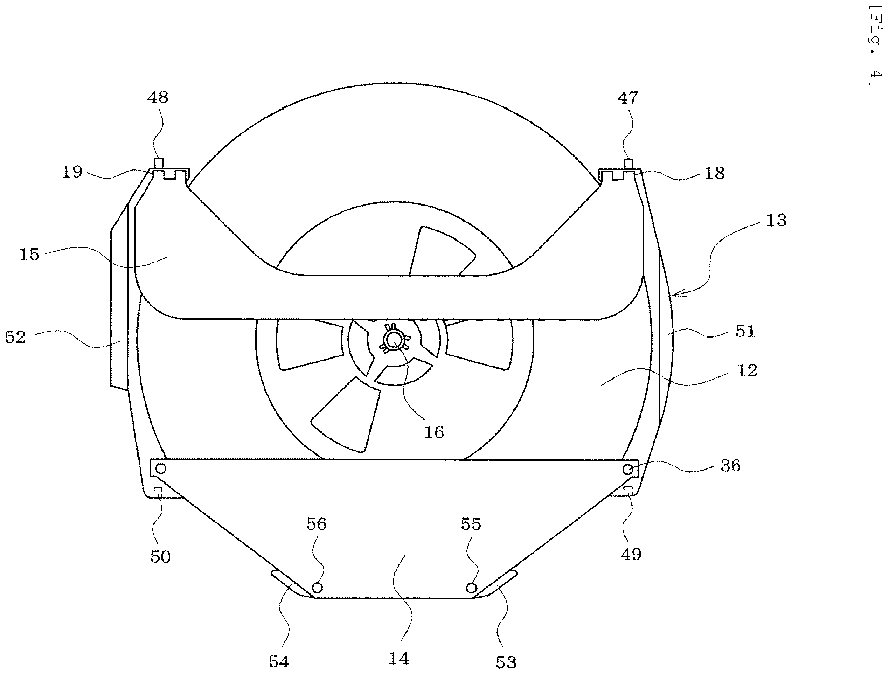

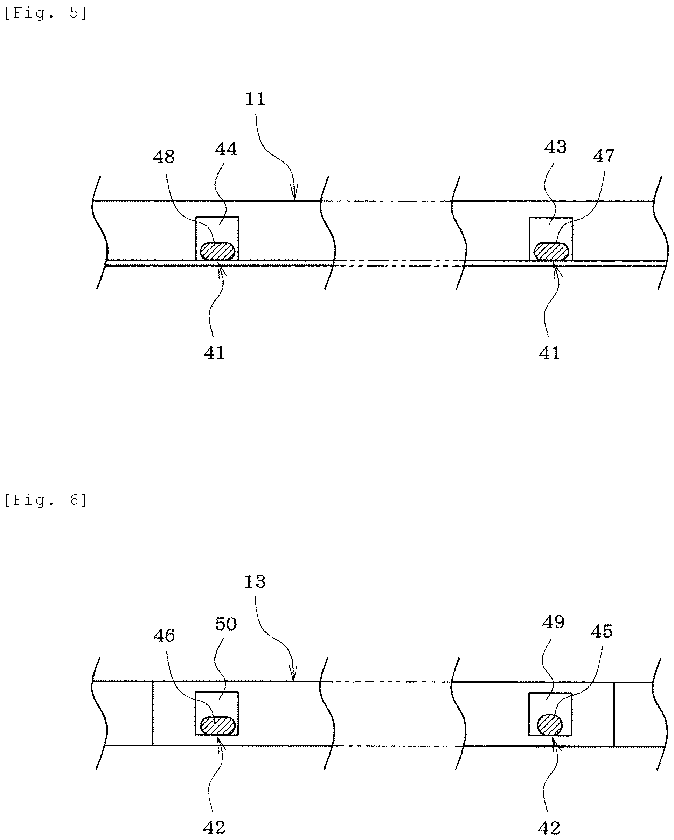

Next, a configuration of a reel displacement mechanism will be described which holds reel holder 13 in such a manner as to be displaced in a width direction (the left-right direction) thereof relative to feeder main body 11. As in the case with Patent Literature 1 described above, a reel displacement mechanism may be configured using a link mechanism; however, in the present embodiment, a reel displacement mechanism is configured using slide mechanisms 41, 42 shown in Figs. 5 and 6. These slide mechanisms 41, 42 are configured of upper slide holes 43, 44 (refer to Figs. 3 and 5), which are provided at both front and rear sides of an upper portion of feeder main body 11 in such a manner as to open downwards, lower projections 45, 46 (refer to Figs. 3 and 6), which are provided at both front and rear sides of a lower portion of feeder main body 11 in such a manner as to project upwards therefrom, upper projections 47, 48 (refer to Figs. 4 and 5), which are provided at both front and rear sides of an upper portion of reel holder 13 in such a manner as to project upwards therefrom, and lower slide holes 49, 50 (refer to Figs. 4 and 6), which are provided at both front and rear sides of a lower portion of reel holder 13 in such a manner as to open downwards. As shown in Fig. 5, upper projections 47, 48 of reel holder 13 are fitted in upper slide holes 43, 44 in feeder main body 11, respectively, in such a manner as to slide in a width direction (a left-right direction) of feeder main body 11, and as shown in Fig. 6, lower projections 45, 46 of feeder main body 11 are fitted in lower slide holes 49, 50 in reel holder 13, respectively, in such a manner as to slide in the width direction (the left-right direction) of feeder main body 11, whereby reel holder 13 is held in such a manner as to be displaced in a width direction (a left-right direction) thereof relative to feeder main body 11.

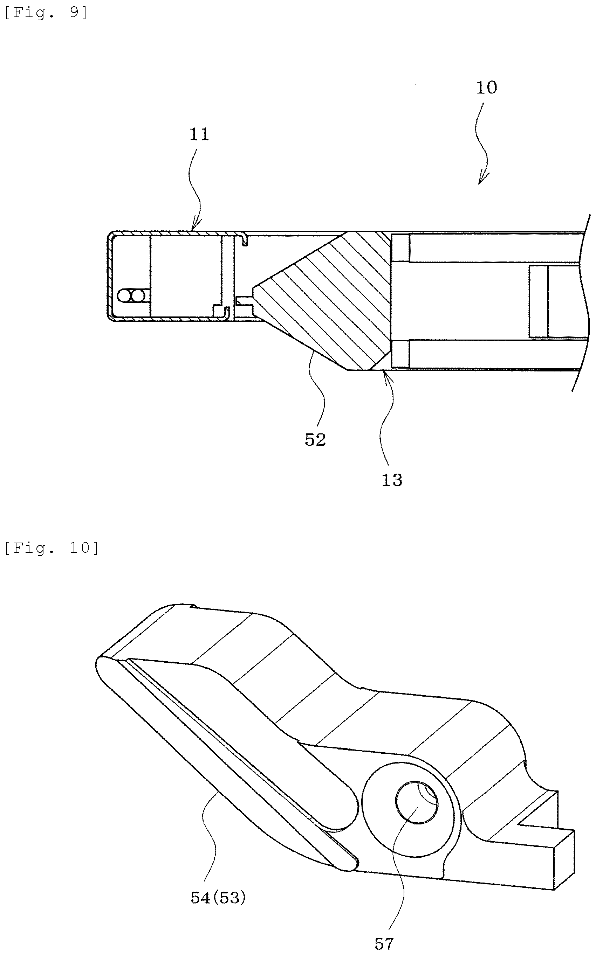

As shown in Figs. 1, 2 and 4, taper surfaces 51, 52 (refer to Fig. 9), having a substantially triangular horizontal cross section, are provided at both end portions in a front-rear direction (attaching and detaching directions) of reel holder 13 so as to allow reel holder 13 to smoothly slide in the width direction thereof. A width of feeder main body 11 is set slightly narrower than an interval or pitch at which slot grooves 33 are formed on feeder setting section 31, whereas as shown in Fig. 9, a width of reel holder 13 is set wider than the width of feeder main body 11 (wider than the pitch at which slot grooves 33 are formed on feeder setting section 31) and at a width of not wider than 1.5 times of the pitch at which slot grooves 33 are formed. As a result, when feeder main body 11 is attached to slot groove 33 on feeder setting section 31, reel holder 13 projects from feeder main body 11 towards an adjacent slot groove 33, and a projection amount of reel holder 13 then is set to be not greater than a half of the pitch at which slot grooves 33 are formed.

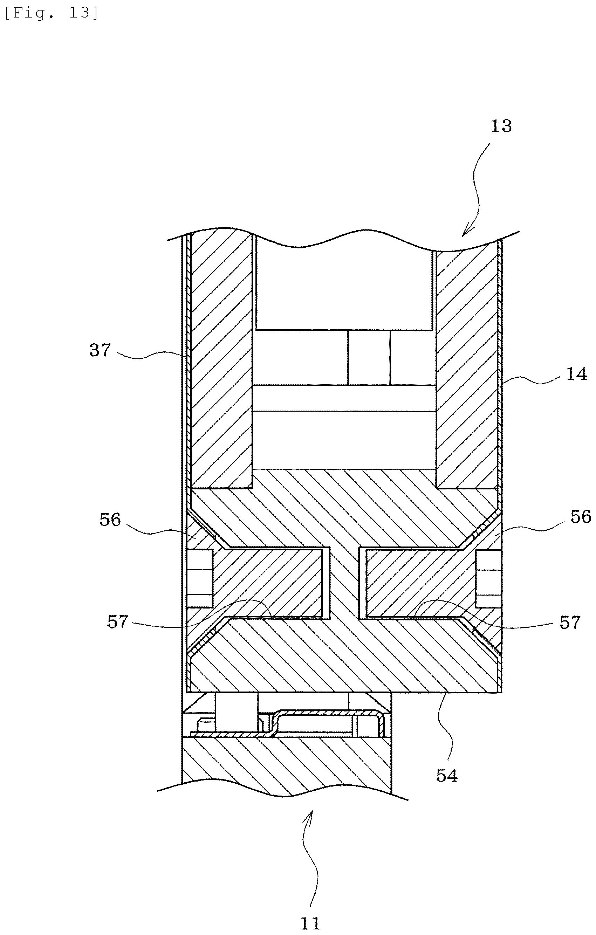

Further, as shown in Figs. 1, 2 and 4, guide sections 53, 54 (refer to Figs. 10 to 13), which are configured to guide end edges of holder covers 14, 37 so as not to be caught by adjacent tape feeder 10 when tape feeder 10 is attached to or detached from feeder setting section 31, are provided at least a lower end portion of both the end portions in the front-rear direction (the attaching and detaching directions) of reel holder 13. In the present embodiment, guide sections 53, 54 are each formed from a resin as a separate member from reel holder 13, and as shown in Figs. 12 and 13, guide sections 53, 54 are attached to reel holder 13 in an exchangeable fashion with screws 55, 56, respectively, which are tightly screwed into screw holes 57 in guide sections 53, 54 from outer sides of holder covers 14, 37 in such a state that guide sections 53, 54 are held between holder covers 14, 37.

Respective portions of guide sections 53, 54, which project in the front-rear direction from the end edges of holder covers 14, 37, each have a taper shape. Further, as show in Fig. 12, outer edge sections of taper surfaces of each of guide sections 53, 54 are formed in such a manner as to protrude transversely outwards from surfaces of guide sections 53, 54 where holder covers 14, 37 are attached by an amount coinciding with a thickness of holder covers 14, 37 or slightly more than the thickness, and guide sections 53, 54 are configured so as to provide a state in which the outer edge sections of the respective taper surfaces of guide sections 53, 54 cover the end edges of holder covers 14, 37 as viewed from the attaching and detaching directions of tape feeder 10.

With the present embodiment that has been described heretofore, since guide sections 53, 54, which are configured to guide tape feeder 10 so that the end edges of holder covers 14, 37 are not caught by adjacent tape feeder 10 when tape feeder 10 in question is attached to or detached from feeder setting section 31, are provided at both the end portions in the front-rear direction of reel holder 13 of tape feeder 10 in question, end edges in the attaching and detaching directions of holder cover 13 of tape feeder 10 to be attached or detached can be prevented from being caught by adjacent tape feeder 10, thereby making it possible to improve the attachability and detachability of tape feeder 10.

Moreover, since guide sections 53, 54 are attached in the exchangeable fashion to both the end portions in the front-rear direction of reel holder 13 with screws 55, 56, guide sections 53, 54 can be provided separately from tape feeders 10 to the user as an exchangeable repair part, whereby the user can exchange guide sections 53, 54 which get worn or damaged as a result of being used for a long period of time with new exchangeable repair parts as required, thereby making it possible to extend the life of tape feeder 10.

The present invention is not limited to the embodiment that has been described heretofore, and can be carried out by being modified variously without departing from the scope of the present invention, which is solely defined by the appended claims. Resulting modifications may include, for example, configurations in which the positions, shapes and lengths of guide sections 53, 54 are changed as required, the positions, shapes, and sizes of holder covers 14, 37 are changed as required, and the configuration of feeder main body 11 and/or the configuration of reel holder 13 is modified as required.

### REFERENCE SIGNS LIST

10 tape feeder, 11 feeder main body, 12 tape reel, 13 reel holder, 14 holder cover, 15 reel presser plate, 23 guide rail, 31 feeder setting section, 33 slot groove, 35 hole section, 37 holder cover, 41, 42 slide mechanism (reel displacement mechanism), 43, 44 upper slide hole, 45, 46 lower projection, 47, 48. upper projection, 49, 50 lower slide hole, 53, 54 guide section.

## Claims

1. A tape feeder (10) configured to be attached to and detached from a feeder setting section (31) of a component mounter, the tape feeder (10) comprising:
a feeder main body (11);
a reel holder (13) configured to load a tape reel (12) around which a component supply tape is wound;
a reel displacement mechanism (41, 42) for holding the reel holder (13) in such a manner as to be displaced in a width direction thereof relative to the feeder main body (11);
a holder cover (14, 37) of sheet metal which is attached to at least a part of a side surface of the reel holder (13); and
guide sections (53, 54) provided at both end portions of the reel holder (13) in attaching and detaching directions to guide the tape feeder (10) when the tape feeder (10) is attached to or detached from the feeder setting section (31) in such manner that end edges in the attaching and detaching directions of the holder cover (14, 37) of the tape feeder (10) are not caught by an adjacent tape feeder,
wherein respective portions of the guide sections (53, 54) that project in the attaching and detaching directions from the end edges of the holder covers (14, 37) each have a taper shape, outer edge sections of taper surfaces of each of the guide sections (53, 54) are formed in such a manner as to protrude transversely outwards from surfaces of the guide sections (53, 54) where the holder covers (14, 37) are attached by an amount coinciding with a thickness of the holder covers (14, 37) or slightly more than the thickness, and the guide sections (53, 54) are configured so as to provide a state in which the outer edge sections of the respective taper surfaces of the guide sections (53, 54) cover the end edges of the holder covers (14, 37) as viewed from the attaching and detaching directions of the tape feeder (10),
**characterized in that**
the guide sections (53, 54) are attached to both end portions of the reel holder (13) in the attaching and detaching directions in an exchangeable manner.

2. The tape feeder (10) according to claim 1,
wherein the holder cover (14, 37) is provided so as to extend as far as at least a lower end portion of a side face of the reel holder (13), and
wherein the guide sections (53, 54) are provided at at least a lower end portion of both the end portions in the attaching and detaching directions of the reel holder (13).

3. The tape feeder (10) according to claim 1 or 2,
wherein a hole section (35) is provided in the feeder main body (11) in such a manner that the reel holder (13) can pass therethrough in a width direction thereof.

4. The tape feeder (10) according to any one of claims 1 to 3,
wherein the reel displacement mechanism (41, 42) is configured of a slide mechanism for supporting the reel holder (13) in such a manner that the reel holder (13) can slide in the width direction thereof.

## Patentansprüche

1. Bandzuführung (10), die konfiguriert ist, um an einem Zuführungseinrichtungsabschnitt (31) einer Komponentenmontagevorrichtung befestigt und von diesem getrennt zu werden, wobei die Bandzuführung (10) umfasst:
einen Zuführungshauptkörper (11);
einen Spulenhalter (13), der konfiguriert ist, eine Bandspule (12) zu laden, um die ein Komponentenzuführungsband gewickelt ist;
einen Spulenversatzmechanismus (41, 42) zum Halten des Spulenhalters (13) so, dass er in einer Breitenrichtung davon bezüglich des Zuführungshauptkörpers (11) versetzt wird;
eine Halterabdeckung (14, 37) aus Blechmetall, die an mindestens einem Teil einer Seitenfläche des Spulenhalters (13) befestigt ist; und
Führungsabschnitte (53, 54), die an beiden Endabschnitten des Spulenhalters (13) in Befestigungs- und Trennrichtung bereitgestellt sind, um die Bandzuführung (10) zu führen, wenn die Bandzuführung (10) an dem Zuführungseinrichtungsabschnitt (31) befestigt oder davon getrennt wird, so dass Endkanten in der Befestigungs- und Trennrichtung der Halterabdeckung (14, 37) der Bandzuführung (10) nicht an einer benachbarten Bandzuführung hängen bleiben,
wobei jeweilige Abschnitte der Führungsabschnitte (53, 54), die in der Befestigungs- und Trennrichtung von den Endkanten der Halterabdeckung (14, 37) vorstehen, jeweils eine sich verjüngende Form aufweisen, Außenkantenabschnitte von Verjüngungsflächen von jedem der Führungsabschnitte (53, 54) so ausgebildet sind, dass sie transversal nach außen von Flächen der Führungsabschnitte (53, 54), wo die Halterabdeckung (14, 37) befestigt sind, um ein Ausmaß vorstehen, das mit einer Dicke der Halterabdeckung (14, 37) übereinstimmt oder geringfügig mehr als die Dicke beträgt und die Führungsabschnitte (53, 54) konfiguriert sind, einen Zustand bereitzustellen, in welchem die Außenkantenabschnitte der jeweiligen Verjüngungsflächen der Führungsabschnitte (53, 54) die Endkanten der Halterabdeckung (14, 37) aus der Befestigungs- und Trennrichtung der Bandzuführung (10) gesehen bedecken,
**dadurch gekennzeichnet, dass**
die Führungsabschnitte (53, 54) an beiden Endabschnitten des Spulenhalters (13) in der Befestigungs- und Trennrichtung in einer austauschbaren Weise befestigt sind.

2. Die Bandzuführung (10) nach Anspruch 1,
wobei die Halterabdeckung (14, 37) so bereitgestellt ist, dass sie sich so weit wie zumindest ein unterer Endabschnitt einer Seitenfläche des Spulenhalters (13) erstreckt, und
wobei die Führungsabschnitte (53, 54) zumindest an einem unteren Endabschnitt von beiden Endabschnitten in der Befestigungs- und Trennrichtung des Spulenhalters (13) bereitgestellt sind.

3. Die Bandzuführung (10) nach Anspruch 1 oder 2,
wobei ein Lochabschnitt (35) in dem Zuführungshauptkörper (11) so bereitgestellt ist, dass der Spulenhalter (13) in einer Breitenrichtung davon hindurchgehen kann.

4. Die Bandzuführung (10) nach einem der Ansprüche 1 bis 3,
wobei der Spulenversatzmechanismus (41, 42) von einem Schiebemechanismus zum Stützen des Spulenhalters (13) gebildet wird, so dass der Spulenhalter (13) in der Breitenrichtung davon gleiten kann.

## Revendications

1. Chargeur de bande (10) configuré pour être attaché et détaché d'une section de réglage de chargeur (31) d'un dispositif de montage de composants, le chargeur de bande (10) comportant :
un corps principal de chargeur (11) ;
un support de bobine (13) configuré pour charger une bobine de ruban (12) autour de laquelle un ruban d'alimentation de composant est enroulé ;
un mécanisme de déplacement de bobine (41, 42) pour maintenir le support de bobine (13) de telle manière qu'il se déplace dans une direction de sa largeur par rapport au corps principal de chargeur (11) ;
un couvercle de support (14, 37) en tôle qui est attaché à au moins une partie d'une surface latérale du support de bobine (13) ; et
des sections de guidage (53, 54) situées au niveau des deux parties d'extrémité du support de bobine (13) dans des directions d'attachement et de détachement pour guider le chargeur de bande (10) lorsque le chargeur de bande (10) est attaché ou détaché de la section de réglage de chargeur (31) de telle manière que des bords d'extrémité dans les directions d'attachement et de détachement du couvercle de support (14, 37) du chargeur de bande (10) ne se prennent pas dans un chargeur de bande adjacent,
où des parties respectives des sections de guidage (53, 54) qui font saillie dans les directions d'attachement et de détachement à partir des bords d'extrémité des couvercles de support (14, 37) ont chacune une forme conique, des sections de bord extérieur de surfaces coniques de chacune des sections de guidage (53, 54) sont formées de telle sorte qu'elles dépassent transversalement vers l'extérieur à partir de surfaces des sections de guidage (53, 54) où les couvercles de support (14, 37) sont attachés, d'un montant coïncidant avec une épaisseur des couvercles de support (14, 37) ou légèrement plus important que l'épaisseur, et les sections de guidage (53, 54) sont configurées de manière à obtenir un état dans lequel les sections de bord extérieur des surfaces coniques respectives des sections de guidage (53, 54) couvrent les bords d'extrémité des couvercles de support (14, 37) dans une vue depuis les directions d'attachement et de détachement du chargeur de bande (10),
**caractérisé en ce que**
les sections de guidage (53, 54) sont attachées aux deux parties d'extrémité du support de bobine (13) dans les directions d'attachement et de détachement d'une manière interchangeable.

2. Chargeur de bande (10) selon la revendication 1,
où le couvercle de support (14, 37) est situé de manière à s'étendre jusqu'à au moins une partie d'extrémité inférieure d'une face latérale du support de bobine (13), et
où les sections de guidage (53, 54) sont situées au niveau d'au moins une partie d'extrémité inférieure des deux parties d'extrémité dans les directions d'attachement et de détachement du support de bobine (13).

3. Chargeur de bande (10) selon la revendication 1 ou 2,
où une section de trou (35) est située dans le corps principal de chargeur (11) de telle manière que le support de bobine (13) peut passer à travers dans la direction de sa largeur.

4. Chargeur de bande (10) selon l'une quelconque des revendications 1 à 3,
où le mécanisme de déplacement de la bobine (41, 42) est configuré comme un mécanisme de glissement pour maintenir le support de bobine (13) de telle manière que le support de bobine (13) peut glisser dans le sens de sa largeur.
